# EUROPEAN PATENT SPECIFICATION

(11) **EP 2 031 668 B1**
(45) Date of publication and mention of the grant of the patent: **12.12.2012**
(21) Application number: 08014917.2
(22) Date of filing: 22.08.2008
(51) Int. Cl.: H01L 39/24

(54) **Nb3Sn superconducting wire fabricated by bronze process and precursor therefor**
Nb3Sn-Supraleitdraht, der in einem Bronzeverfahren hergestellt wurde, sowie Vorläufer dafür
Câble supraconducteur Nb3Sn fabriqué par un procédé de bronze et son précurseur

(30) Priority: 03.09.2007 JP 2007227672
(43) Date of publication of application: 04.03.2009
(73) Proprietor: Kabushiki Kaisha Kobe Seiko Sho (Kobe Steel, Ltd.), Kobe-shi, Hyogo 651-8585 (JP)
(72) Inventor: Zaitsu, Kyoji, Kobe-shi, Hyogo 651-2271 (JP); Hase, Takashi, Kobe-shi, Hyogo 651-2271 (JP); Kato, Hiroyuki, Kobe-shi, Hyogo 651-2271 (JP); Miyatake, Takayuki, Kobe-shi, Hyogo 651-2271 (JP); Murakami, Yukinobu, Kitayushu-shi, Fukuoka (JP)
(74) Representative: Müller-Boré & Partner Patentanwälte

(56) References cited:
- US-A1- 2005 178 472
- US-A1- 2006 032 042

## Description

The present invention relates to a precursor for making a Nb₃Sn superconducting wire by a bronze process (hereinafter may also be referred to as "superconducting wire precursor"), and a Nb₃Sn superconducting wire fabricated using such a precursor. More particularly, the invention relates to a Nb₃Sn superconducting wire useful as a material for superconducting magnets and a precursor for the Nb₃Sn superconducting wire.

Examples of the practical use of superconducting wires include superconducting magnets that are used for high-resolution nuclear magnetic resonance (NMR) analyzers, nuclear fusion devices, accelerators, etc. In the superconducting magnets, since it is required to improve the resolution of NMR signals and to reduce data acquisition time, there are demands for higher magnetic fields. With respect to the higher magnetic fields and the smaller size of superconducting magnets, it is essential to enhance the performance of superconducting wires used for the superconducting magnets. In particular, it is required to enhance the performance of superconducting coils used in innermost layer portions of the superconducting magnets.

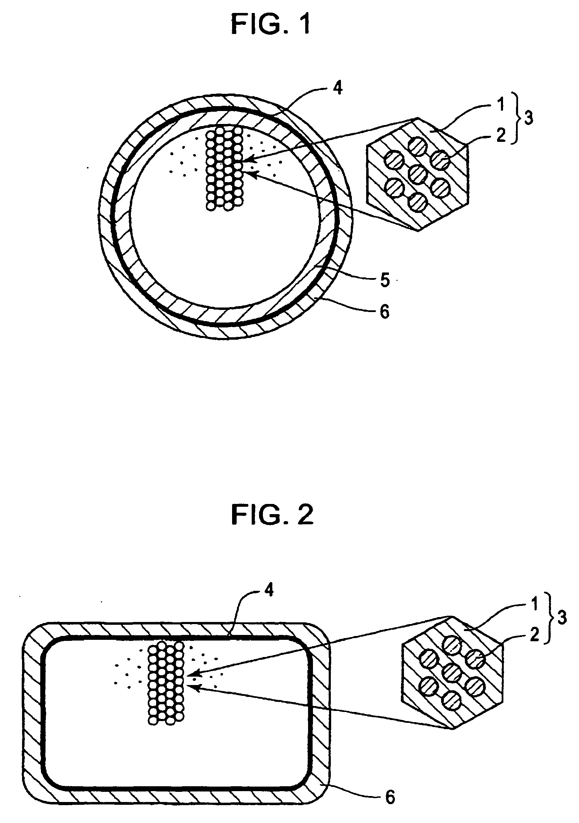

As metal-based superconducting wires used for such superconducting magnets, Nb₃Sn wires have been put into practical use. A bronze process is mainly applied to make the Nb₃Sn superconducting wires. In the bronze process, as shown in Fig. 1, which is a schematic diagram of a precursor for making a Nb₃Sn superconducting wire, one or a plurality of (seven in Fig. 1) cores 2 composed of Nb or a Nb-based alloy (e.g., a Nb-Ta alloy) are embedded in a Cu-Sn-based alloy (bronze) matrix 1 to constitute a primary stack member 3. The primary stack member 3 is formed so as to have a hexagonal cross section as shown in Fig. 1.

The primary stack member 3 is subjected to area reduction, such as wire drawing or extrusion, so that the cores 2 have a smaller diameter and are formed into filaments (hereinafter may be referred to as "Nb-based filaments"). A plurality of primary stack members 3, each being composed of the Nb-based filaments and bronze, are bundled into a wire group. The wire group is inserted into a pipe-shaped Cu or Cu-based alloy member 5 around which a Nb sheet or a Ta sheet serving as a diffusion barrier layer 4 is wound, or a Nb sheet or a Ta sheet is directly wound around the wire group obtained by bundling a plurality of primary stack members 3, and stabilizing copper 6 is arranged in the periphery thereof. Thereby, a secondary multi-core billet is formed. Note that the pipe-shaped Cu or Cu-based alloy member 5 may be composed of a Cu-Sn-based alloy.

The secondary multi-core billet is subjected to hydrostatic extrusion and then to area reduction by drawing, thus being formed into a precursor in which the cross-sectional shape shown in Fig. 1 is maintained, or a precursor for making a superconducting wire which is a flat-type wire having a rectangular cross section as shown in Fig. 2 (hereinafter may be simply referred to as "precursor").

The precursor (i.e., wire which has been subjected to drawing) is subjected to diffusion heat treatment (heat treatment for Nb₃Sn generation) at about 600°C to 700°C for about 100 to 300 hours to generate Nb₃Sb compound layers at the interfaces between the bronze matrix and the Nb-based filaments.

A supercurrent flows through a Nb₃Sn phase generated by subjecting the wire precursor to the diffusion heat treatment. The Nb₃Sn phase is highly sensitive to mechanical strain, and even at an amount of strain of only about 1%, superconducting properties (in particular, critical current density Jc) degrade sharply.

When a Nb₃Sn superconducting wire is used, substantially all of the wire is in a superconducting magnet state. In a superconducting magnet, an electromagnetic force constantly acts on the wire due to the magnetic field of the magnet and an applied current. Furthermore, in the Nb₃Sn superconducting wire, heat treatment for Nb₃Sn generation is performed at a high temperature close to 700°C, and a current is applied at a cryogenic temperature of 4.2 K or lower. Consequently, a force due to the thermal contraction of Cu arranged in the periphery also acts on the Nb₃Sn phase. Thus, the properties are degraded due to strain.

For example, in an international thermonuclear experimental reactor (ITER) or a conductor for accelerator use, through which a large amount of current is required to pass, since a plurality of Nb₃Sn superconducting wires are twisted together for use, the stresses applied to the wires are complex. In recent years, countermeasures have been required to cope with the strain in the radial direction (in the direction of the radius of the perimeter of the wires) in addition to the strain in the length direction.

In order to cope with the strain, it is most effective to increase the strength of superconducting wires. Techniques for such a purpose are disclosed, for example, in Japanese Unexamined Patent Application Publication No. 2001-236836 (Patent Document 1) and Japanese Unexamined Patent Application Publication No. 2003-86032 (Patent Document 2). In each of these techniques, a composite filament is formed in which a reinforcing member (for example, composed of Ta) is embedded in the center of a Nb-based filament so that the degradation in properties due to strain is suppressed.

Such a technique is effective in increasing the strength of a superconducting wire. However, since the reinforcing member is embedded in the Nb-based filament which is finally to be highly deformed so as to have an outer diameter of about 2 to 10 µm, the reinforcing member will have a smaller diameter than this, and there is a possibility that the risk of breaking or the like will increase during wire drawing. Furthermore, it is necessary to add a step of embedding the reinforcing member in the Nb-based filament to the existing process of fabricating the Nb₃Sn superconducting wire precursor by the bronze process, resulting in an increase in cost.

A further example may be found in Patent Application US 2006/032042.

The present invention has been achieved under these circumstances. It is an object of the invention to increase the mechanical strength of a Nb₃Sn superconducting wire fabricated by a bronze process and to provide a structure which makes it possible to easily obtain, without problems in terms of working, a Nb₃Sn superconducting wire excellent in terms of superconducting properties, the Nb₃Sn superconducting wire being made by the bronze process, and a precursor for making such a superconducting wire.

A Nb₃Sn superconducting wire precursor according to the present invention, which can achieve the object described above, is a precursor used for making a Nb₃Sn superconducting wire by a bronze process, the precursor being in the shape of a wire, which includes an aggregate obtained by bundling (A) a plurality of superconducting composite elements, each including one or a plurality of Nb or Nb-based alloy filaments disposed in a Cu-Sn-based alloy matrix and (B) a plurality of reinforcing composite elements, each including one or a plurality of Ta or Ta-based alloy filaments disposed in a Cu-Sn-based alloy matrix; a diffusion barrier layer disposed in the periphery of the aggregate; and stabilizing copper arranged in the periphery of the diffusion barrier layer. The ratio of the cross-sectional area of the Ta or Ta-based alloy filaments disposed in the reinforcing composite elements to the cross-sectional area of the precursor wire is 2% to 15%. The reinforcing composite elements are present at a position in a range of 0.7D to 0.9D in the radial direction, where D is an outer diameter of the precursor wire.

In the Nb₃Sn superconductor wire precursor of the present invention, for example, (a) the reinforcing composite elements may be disposed continuously over the entire periphery in the circumferential direction of the precursor wire, and/or (b) the reinforcing composite elements may be disposed in a region between the superconducting composite elements and the diffusion barrier layer.

Preferably, the reinforcing composite elements have the same hexagonal cross-sectional outer shape as the superconducting composite elements. Furthermore, the diffusion barrier layer may be composed of Nb or a Nb-based alloy, or Ta or a Ta-based alloy.

Furthermore, preferably, (a) the ratio of the cross-sectional area of one or a plurality of Nb or Nb-based alloy filaments disposed in each superconducting composite element to the cross-sectional area of the Cu-Sn-based alloy matrix is 30% to 50%. Preferably, (b) the ratio of the cross-sectional area of one or a plurality of Ta or Ta-based filaments disposed in each reinforcing composite element to the cross-sectional area of the Cu-Sn-based alloy matrix is 30% to 300%.

A Nb₃Sn superconducting wire exhibiting desired superconducting properties (critical current density Jc and strength) can be made by diffusion heat treatment to any of the various superconducting wire precursors described above.

In the present invention, in a precursor formed during the making process of a Nb₃Sn superconducting wire by the bronze process, by applying a structure in which a part of the region where Nb filaments are disposed is replaced with reinforcing metal members so that a predetermined area ratio is satisfied, it is possible to obtain a superconducting wire having a sufficient strength while maintaining good superconducting properties.
Fig. 1 is a cross-sectional view schematically showing an example of a structure of a precursor for making a superconducting wire, which is applicable to a bronze process;
Fig. 2 is a cross-sectional view schematically showing another example of a structure of a precursor for making a superconducting wire, which is applicable to a bronze process;
Fig. 3 is a graph showing the relationships between the cross-sectional area ratio of Ta or a Ta-based alloy serving as reinforcing members and each of the 0.2% proof stress and the critical current density Jc; and
Fig. 4 is a cross-sectional view schematically showing an example of a structure of a precursor according to an embodiment of the present invention.

In a precursor wire according to the present invention, when a superconducting wire precursor such as the one shown in Fig. 1 or 2 is formed, a structure is employed in which some of the Cu-Sn/Nb composite wires (i.e., primary stack members 3 shown in Fig. 1 or 2) constituting the precursor are replaced with Cu-Sn/Ta composite wires where Ta or a Ta-based alloy is arranged as reinforcing members. Consequently, it is not necessary to perform a special operation, such as embedding a reinforcing member in each Nb-based filament when the precursor is formed, and it is possible to fabricate the precursor relatively easily.

When a Nb₃Sn superconducting wire is made by the bronze process, final heat treatment (diffusion heat treatment) is performed at about 600°C to 700°C for about 100 to 300 hours as described above. In the metal or alloy disposed in the reinforcing composite elements according to the present invention, the level of softening due to the heat treatment needs to be low (high-melting-point metal), and also high workability is required. Furthermore, the metal or alloy is required to have sufficiently high mechanical strength (e.g., 0.2% proof stress σ_{0.2}) at a low temperature of 4.2 K.

From such standpoints, it has been conceived that a metal having a body-centered cubic structure is most suitable as the metal or alloy used in the present invention. In such a metal having the body-centered cubic structure, although the phenomenon of low-temperature brittleness easily occurs, thus decreasing elongation (increasing brittleness), tensile strength is high. Furthermore, in the final heat treatment, unreactiveness with Sn is also an important factor. That is, if the reaction with Sn occurs actively, Sn, which is supposed to form Nb₃Sn, combines with the reinforcing members, resulting in a decrease in the amount of Nb₃Sn phase. Thus, it is not possible to obtain sufficient superconducting properties.

In the reinforcing composite elements used in the present invention, as the metal or alloy that satisfies the requirements described above, Ta or a Ta-based alloy is selected, and such a material (Ta or Ta-based alloy filament) is disposed as a reinforcing member in the Cu-Sn-based alloy. By replacing some of the superconducting composite elements in which Nb-based filaments are disposed in the Cu-Sn-based alloy (corresponding to the primary stack members 3 shown in Fig. 1 or 2) with the reinforcing composite elements, the desired effect of enhancing strength can be obtained in spite of a relatively simple structure.

If some of the superconducting composite elements are replaced with the reinforcing composite elements, the area of the superconducting portion (Nb₃Sn phase) decreases, resulting in a decrease in the critical current density Jc with respect to the entire cross-sectional area. Therefore, there is a limit in increasing the strength by increasing the arrangement ratio of the reinforcing composite elements.

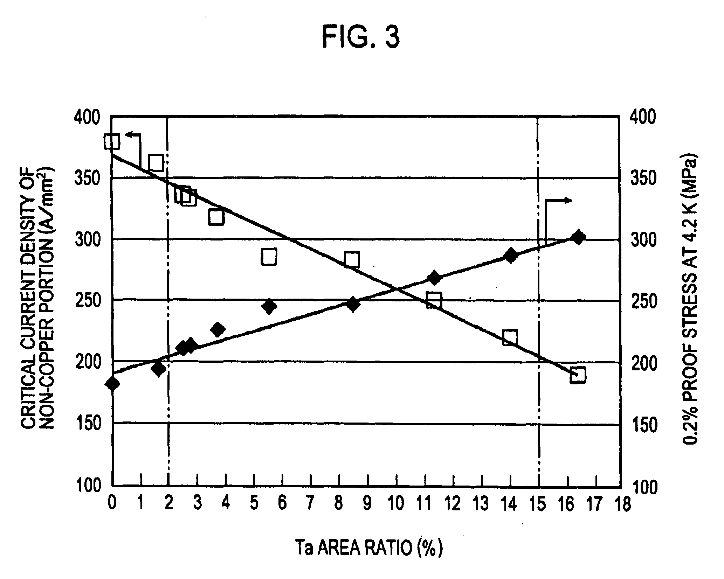

Fig. 3 shows influences of the Ta area ratio on the 0.2% proof stress and the critical current density Jc. The Ta area ratio is defined as the cross-sectional area ratio of Ta or the Ta-based alloy as the reinforcing members, i.e., the ratio of the cross-sectional area of the reinforcing members to the cross-sectional area of the entire wire, when the reinforcing composite elements in which Ta or Ta-based alloy filaments are disposed in the Cu-Sn-based alloy matrix are used. The methods for measuring the 0.2% proof stress and the critical current density Jc and the fabrication conditions for the superconducting wire will be described in Examples below.

As is evident from Fig. 3, as the Ta area ratio increases, the strength (0.2% proof stress σ_{0.2}) increases as well as the critical current density Jc decreases. In an external magnetic field of 15 T (tesla) which is practically required in the general Nb₃Sn superconducting wire, the critical current density Jc and the 0.2% proof stress σ_{0.2} are about 200 to 350 A/mm² and about 200 to 300 MPa, respectively. Consequently, in the Nb₃Sn superconducting wire fabricated by the bronze process, in order to satisfy both of the above properties, the area ratio of the reinforcing members (Ta area ratio) must be about 2% to 15%. The area ratio is preferably in a range of about 5% to 12%.

In the precursor of the present invention, a plurality of primary stack members (superconducting composite elements) 3 such as the ones shown in Fig. 1 or 2 and a plurality of reinforcing composite elements having the structure as described above are bundled into a wire group (aggregate), the aggregate is inserted into a pipe composed of Cu or a Cu alloy (e.g., Cu-Sn), and then diameter reduction is performed to form a superconducting wire precursor.

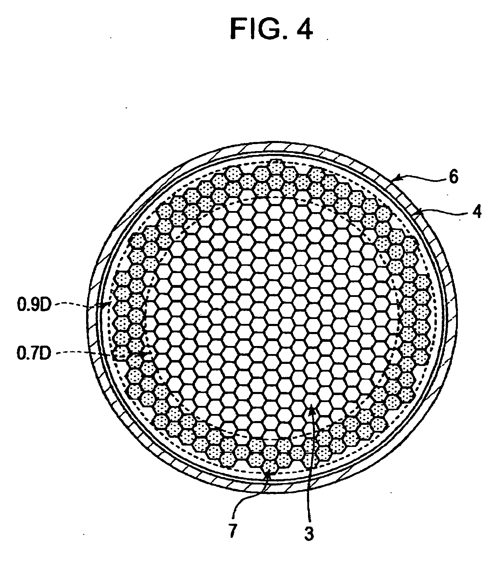

The structure of a precursor of the present invention will be described with reference to the drawings. Fig. 4 is a cross-sectional view schematically showing an example of a structure of a precursor according to an embodiment of the present invention. The basic structure is similar to the structure shown in Fig. 1, and the same reference numerals are used to indicate the corresponding components, and duplicate descriptions thereof are omitted.

In the precursor shown in Fig. 4, primary stack members (superconducting composite elements) 3 are bundled into a wire group (aggregate) and disposed in the center of the precursor wire, and a plurality of reinforcing composite elements 7 are disposed continuously over the entire periphery in the circumferential direction of the aggregate.

When the bending strain to the wire is taken into consideration, the amount of strain increases with distance from the centerline of the wire. In the structure shown in Fig. 4, by disposing the reinforcing composite elements (i.e., Ta or a Ta-based alloy as reinforcing members) at the position where strain applied to the superconducting composite elements (primary stack members) 3 increases (i.e., the region between the superconducting composite elements and the diffusion barrier layer), it is possible to obtain a wire that has higher resistance to bending strain.

In the precursor of the present invention, since the diffusion barrier layer 4 and stabilizing copper 6 must be arranged in the periphery of the wire, the reinforcing composite elements are required to be present at a position in a range of 0.9D or less in the radial direction, where D is an outer diameter of the wire (precursor). Furthermore, in view of the point described above, the lower limit of the range of the position where the reinforcing composite elements are present is required to be 0.7D. That is, by setting the position where the reinforcing composite elements are present in the range of 0.7D to 0.9D, the reinforcing members also protect the superconducting portion located in the interior thereof from strain in the radial direction. Thus, an advantage that cannot be obtained in the existing superconducting wire can be provided. Furthermore, preferably, the reinforcing composite elements are present in a range of 0.7D to 0.8D.

The reinforcing composite elements may be disposed discontinuously in the circumferential direction of the wire. However, from the standpoints of the uniformity in the circumferential direction and realization of strength, the reinforcing composite elements are preferably disposed continuously over the entire periphery in the circumferential direction of the cross section of the precursor wire.

In the precursor of the present invention, preferably, the reinforcing composite elements have the same hexagonal cross-sectional outer shape as the superconducting composite elements (the primary stack members 3 shown in Fig. 1). By employing such a structure, the process of bundling and combining the superconducting composite elements and the reinforcing composite elements can be facilitated. Furthermore, each of these elements (superconducting composite elements and the reinforcing composite elements) is coated with a Cu-Sn alloy on the surface thereof, and the Cu-Sn alloy surfaces are strongly bonded to each other when combined.

As described above, preferably, the reinforcing composite elements have the same hexagonal cross-sectional outer shape as the superconducting composite elements. However, the superconducting composite elements and the reinforcing composite elements do not necessarily have the same internal shape (the positions where the Nb-based alloy or the Ta-based alloy is embedded) except that Nb or the Nb-based alloy is disposed or Ta or the Ta-based alloy is disposed. For example, the number of Nb or Nb-based alloy filaments may be different from the number of Ta or Ta-based alloy filaments. However, from the standpoint that the same process can be performed for embedding into the Cu-Sn portions, preferably, the superconducting composite elements and the reinforcing composite elements have the same shape as a whole (both the cross-sectional outer shape and the internal shape). Furthermore, the term "same shape" does not necessarily mean strictly the same, and the margin of design error (e.g., about ±1 mm at the stage of insertion into the Cu pipe) is allowable.

In each superconducting composite element, preferably, the ratio of the cross-sectional area of the Nb or Nb-based alloy filaments to the cross-sectional area of the Cu-Sn-based alloy matrix is 30% to 50%. If the cross-sectional area ratio is less than 30%, the Nb portion is small, and it is not possible to obtain sufficient Nb₃Sn layers. If the cross-sectional area ratio exceeds 50%, Sn becomes insufficient, and most of the Nb cores remain unreacted.

Meanwhile, in each reinforcing composite element, preferably, the ratio of the cross-sectional area of the Ta or Ta-based alloy filaments to the cross-sectional area of the Cu-Sn-based alloy matrix is 30% to 300%. If the cross-sectional area ratio is less than 30%, it is not possible to obtain a sufficient reinforcing effect. If the cross-sectional area ratio exceeds 300%, adhesion with the superconducting composite elements decreases. Furthermore, the upper limit of the cross-sectional area ratio is preferably 200% and more preferably 100% or less.

In the precursor of the present invention, a plurality of superconducting composite elements and a plurality of reinforcing composite elements, such as the ones described above, are bundled into an aggregate, and a diffusion barrier layer and stabilizing copper are arranged in the periphery thereof (strictly speaking, in the periphery of the Cu-Sn alloy or Cu-based alloy portion) (refer to Fig. 4). As the material for the diffusion barrier layer, Nb or a Nb-based alloy or Ta or a Ta-based alloy, which has been used in the existing technique, may be employed. Furthermore, as the Nb-based alloy disposed in the superconducting composite elements used in the present invention, a Nb-based alloy containing an element, such as Ta, Ti, or W, in an amount up to about 1% may also be employed. Furthermore, as the Ta-based alloy disposed in the reinforcing composite elements used in the present invention, a Ta-based alloy containing an element, such as Nb, W, or Ti, in an amount up to about 1% may also be employed.

By subjecting the superconducting wire precursor having the structure described above to diffusion heat treatment (for example, at 600°C to 700°C for about 100 to 300 hours), a Nb₃Sn superconducting wire exhibiting good superconducting properties (critical current density Jc) and having proper strength can be obtained.

The present invention will be described more in detail by way of examples. However, it is to be understood that the examples described below do not limit the present invention, and changes in design according to the purposes described above and below are included in the technical scope of the present invention.

### EXAMPLE 1

A Cu-Sn/Nb composite extrusion billet was formed by a method in which seven holes with a diameter of 12 mm were made in a Cu-15%Sn alloy rod with a diameter of 60 mm, one at the center (center of axis) of the alloy rod and others around the center, and then Nb rods having the same size as the holes were inserted into the holes (area ratio of the Nb rods: 41%). The resulting billet was extruded to a diameter of 20 mm, and then wire drawing was performed to form a superconducting composite element having a hexagonal cross section (primary stack member, each side of the hexagon: 1.5 mm).

Meanwhile, a Cu-Sn/Ta composite extrusion billet was formed by a method in which seven holes with a diameter of 12 mm were made in a Cu-15%Sn alloy rod with a diameter of 60 mm, one at the center (center of axis) of the alloy rod and others around the center, and then Ta rods having the same size as the holes were inserted into the holes (area ratio of the Ta rods: 41%). The resulting billet was extruded to a diameter of 20 mm, and then wire drawing was performed to form a reinforcing composite element having a hexagonal cross section (each side of the hexagon: 1.5 mm).

The superconducting composite elements (649 elements) and the reinforcing composite elements (84 elements) were bundled in a Cu pipe (outside diameter: 60 mm, inside diameter: 44 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.7D to 0.71D in the cross section of the wire, and the ratio of the cross-sectional area of the Ta filaments to the entire cross-sectional area of the wire was 2.5%.

### EXAMPLE 2

Superconducting composite elements having a hexagonal cross section and reinforcing composite elements having a hexagonal cross section (each side of the hexagon: 1.5 mm) were formed as in Example 1.

The superconducting composite elements (547 elements) and the reinforcing composite elements (186 elements) were bundled in a Cu pipe (outside diameter: 60 mm, inside diameter: 44 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.70D to 0.74D in the cross section of the wire, and the ratio of the cross-sectional area of the Ta filaments to the entire cross-sectional area of the wire was 5.5%.

### EXAMPLE 3

Superconducting composite elements having a hexagonal cross section and reinforcing composite elements having a hexagonal cross section (each side of the hexagon: 1.5 mm) were formed as in Example 1.

The superconducting composite elements (817 elements) and the reinforcing composite elements (282 elements) were bundled in a Cu pipe (outside diameter: 60 mm, inside diameter: 54.5 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.83D to 0.90D in the cross section of the wire, and the ratio of the cross-sectional area of the Ta filaments to the entire cross-sectional area of the wire was 8.5%.

### EXAMPLE 4

Superconducting composite elements having a hexagonal cross section and reinforcing composite elements having a hexagonal cross section (each side of the hexagon: 1.5 mm) were formed as in Example 1.

The superconducting composite elements (721 elements) and the reinforcing composite elements (378 elements) were bundled in a Cu pipe (outside diameter: 60 mm, inside diameter: 54.5 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.78D to 0.90D in the cross section of the wire, and the ratio of the cross-sectional area of the Ta filaments to the entire cross-sectional area of the wire was 11.4%.

### EXAMPLE 5

Superconducting composite elements having a hexagonal cross section and reinforcing composite elements having a hexagonal cross section (each side of the hexagon: 1.5 mm) were formed as in Example 1.

The superconducting composite elements (631 elements) and the reinforcing composite elements (468 elements) were bundled in a Cu pipe (outside diameter: 60 mm, inside diameter: 54.5 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.75D to 0.90D in the cross section of the wire, and the ratio of the cross-sectional area of the Ta filaments to the entire cross-sectional area of the wire was 14.1%.

### COMPARATIVE EXAMPLE 1

A Cu-Sn/Nb composite extrusion billet was formed by a method in which seven holes with a diameter of 12 mm were made in a Cu-15%Sn alloy rod with a diameter of 60 mm, one at the center (center of axis) of the alloy rod and others around the center, and then Nb rods having the same size as the holes were inserted into the holes (area ratio of the Nb rods: 41%). The resulting billet was extruded to a diameter of 20 mm, and then wire drawing was performed to form a superconducting composite element having a hexagonal cross section (primary stack member, each side of the hexagon: 1.5 mm).

The superconducting composite elements (733 elements) (not with reinforcing composite elements) were bundled in a Cu pipe (outside diameter: 60 mm, inside diameter: 44 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process.

### COMPARATIVE EXAMPLE 2

Superconducting composite elements having a hexagonal cross section and reinforcing composite elements having a hexagonal cross section (each side of the hexagon: 1.5 mm) were formed as in Example 1.

The superconducting composite elements (642 elements) and the reinforcing composite elements (91 elements) were bundled in a Cu pipe (outside diameter: 60 mm, inside diameter: 44 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0D to 0.28D in the cross section of the wire, and the ratio of the cross-sectional area of the Ta filaments to the entire cross-sectional area of the wire was 2.7%.

### COMPARATIVE EXAMPLE 3

Superconducting composite elements having a hexagonal cross section and reinforcing composite elements having a hexagonal cross section (each side of the hexagon: 1.5 mm) were formed as in Example 1.

The superconducting composite elements (607 elements) and the reinforcing composite elements (126 elements) were bundled in a Cu pipe (outside diameter: 60 mm, inside diameter: 44 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.50D to 0.61D in the cross section of the wire, and the ratio of the cross-sectional area of the Ta filaments to the entire cross-sectional area of the wire was 3.7%.

### COMPARATIVE EXAMPLE 4

Superconducting composite elements having a hexagonal cross section and reinforcing composite elements having a hexagonal cross section (each side of the hexagon: 1.5 mm) were formed as in Example 1.

The superconducting composite elements (1,045 elements) and the reinforcing composite elements (54 elements) were bundled in a Cu pipe (outside diameter: 60 mm, inside diameter: 54.5 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.85D to 0.90D in the cross section of the wire, and the of the cross-sectional area of the Ta filaments to the entire cross-sectional area of the wire was 1.6%.

### COMPARATIVE EXAMPLE 5

Superconducting composite elements having a hexagonal cross section and reinforcing composite elements having a hexagonal cross section (each side of the hexagon: 1.5 mm) were formed as in Example 1.

The superconducting composite elements (547 elements) and the reinforcing composite elements (552 elements) were bundled in a Cu pipe (outside diameter: 60 mm, inside diameter: 54.5 mm), and a diffusion barrier layer including two layers, each composed of a 0.2-mm-thick Nb sheet, and formed into a roll was inserted into the Cu pipe so as to surround the bundled elements. Thereby, an extrusion billet was formed. The resulting billet was extruded by hydrostatic extrusion to a diameter of 20 mm, and then wire drawing was performed to form a precursor for fabricating a Nb₃Sn superconducting wire by the bronze process. At that time, the reinforcing composite filaments were present at a position in a range of 0.68D to 0.90D in the cross section of the wire, and the ratio of the cross-sectional area of the Ta filaments to the entire cross-sectional area of the wire was 16.5%.

Each of the composite wires obtained in Examples 1 to 5 and Comparative Examples 1 to 5 was processed so as to have a diameter of 0.8 mm, and heat treatment (diffusion heat treatment) was performed in a vacuum at 650°C for 100 hours. Then, the critical current density Jc was measured before and after the application of strain by the method described below. Furthermore, with respect to each of the composite wires, a sample was subjected to a tensile test while being immersed in liquid helium (4.2 K). Thus, the 0.2% proof stress (σ_{0.2}) was measured. Note that the critical current density Jc is required to be 200 A/mm² or more, and the 0.2% proof stress (σ_{o.2}) is required to be 200 MPa or more.

### [Measurement of critical current density Jc]

A current was applied to a sample (superconducting wire) in liquid helium (temperature 4.2 K) in the presence of an external magnetic field of 15 T, and the generated voltage was measured by the four-terminal method. The current value at which an electric field of 0.1 µV/cm was generated (critical current Ic) was determined. The current value was divided by the area of the non-copper parts in the cross-sectional area of the wire to obtain the critical current density Jc of the non-copper parts (critical current density Jc before the application of strain). The critical current density Jc after the application of a strain of 0.4% to the superconducting wire was also measured. The strain was applied by placing the wire on a concave jig (radius of curvature: 100 mm) prepared so that the bending strain was 0.4%, and then by pressing the wire with a convex jig (radius of curvature: 101 mm).

The results (critical current density Jc and 0.2% proof stress) are shown in Table 1 below, which also shows the outside diameter of the billet, the inside diameter of the billet, the number of superconducting composite elements, the number of reinforcing composite elements, the region where the reinforcing composite elements are present, the Ta area ratio, and the final diameter of the wire.

**TABLE 1**

| | Example | | | | | Comparative Example | | | | |
|---|---|---|---|---|---|---|---|---|---|---|
| | 1 | 2 | 3 | 4 | 5 | 1 | 2 | 3 | 4 | 5 |
| Outside diameter of billet (mm) | 60 | 60 | 60 | 60 | 60 | 60 | 60 | 60 | 60 | 60 |
| Inside diameter of billet (mm) | 44 | 44 | 54.5 | 54.5 | 54.5 | 44 | 44 | 44 | 54.5 | 54.5 |
| Number of superconducting composite elements | 649 | 547 | 817 | 721 | 631 | 733 | 642 | 607 | 1045 | 547 |
| Number of reinforcing composite elements | 84 | 186 | 282 | 378 | 468 | 0 | 91 | 126 | 54 | 552 |
| Region where reinforcing composite elements are present (D) | 0.7∼ 0.71 | 0.7∼ 0.74 | 0. 83∼ 0.90 | 0.78∼ 0.90 | 0.75∼ 0.90 | - | 0∼ 0.28 | 0.50∼ 0.61 | 0.85∼ 0.90 | 0.68∼ 0.90 |
| Ta area ratio (%) | 2.5 | 5.5 | 8.5 | 11.4 | 14.1 | 0 | 2.7 | 3.7 | 1.6 | 16.5 |
| Final diameter of wire (mm) | 0.8 | 0.8 | 0.8 | 0.8 | 0.8 | 0.8 | 0.8 | 0. 8 | 0.8 | 0. 8 |
| 02% Proof stress σ₀₂(MPa) | 210 | 244 | 245 | 266 | 286 | 182 | 212 | 224 | 194 | 301 |
| Critical current density Jc before application of bending strain (A/mm²) | 336 | 284 | 282 | 249 | 218 | 380 | 333 | 317 | 361 | 189 |
| Critical current density Jc after application of bending strain (A/mm²) | 214 | 209 | 230 | 231 | 201 | 198 | 190 | 186 | 196 | 179 |

As is evident from the results, in each of the samples of Examples 1 to 5 which satisfy the requirements defined in the present invention, good critical current density Jc values (200 A/mm² or higher) are obtained, and a 0.2% proof stress (σ_{0.2}) of 200 MPa or more is properly ensured.

In contrast, in each of the samples of Comparative Examples 1 to 5 which lack any of the requirements defined in the present invention, at least one of the critical current density Jc (before or after the application of strain) and the 0.2% proof stress (σ_{0.2}) does not satisfy the target value.

## Claims

1. A Nb₃Sn superconducting wire precursor used for fabricating a Nb₃Sn superconducting wire by a bronze process, the precursor being in the shape of a wire, comprising:
an aggregate obtained by bundling (A) a plurality of superconducting composite elements, each including one or a plurality of Nb or Nb-based alloy filaments disposed in a Cu-Sn-based alloy matrix and (B) a plurality of reinforcing composite elements, each including one or a plurality of Ta or Ta-based alloy filaments disposed in a Cu-Sn-based alloy matrix;
a diffusion barrier layer disposed in the periphery of the aggregate; and
stabilizing copper arranged in the periphery of the diffusion barrier layer, **characterized in that**
the ratio of the cross-sectional area of the Ta or Ta-based alloy filaments disposed in the reinforcing composite elements to the cross-sectional area of the precursor wire is 2% to 15%, and the reinforcing composite elements are present at a position in a range of 0.7D to 0.9D in the radial direction, where D is an outer diameter of the precursor wire.

2. The Nb₃Sn superconducting wire precursor according to Claim 1, wherein the reinforcing composite elements are disposed continuously over the entire periphery in the circumferential direction of the cross section of the precursor wire.

3. The Nb₃Sn superconducting wire precursor according to Claim 1 or 2, wherein the reinforcing composite elements are disposed in a region between the superconducting composite elements and the diffusion barrier layer.

4. The Nb₃Sn superconducting wire precursor according to any one of Claims 1 to 3, wherein the reinforcing composite elements have the same hexagonal cross-sectional outer shape as the superconducting composite elements.

5. The Nb₃Sn superconducting wire precursor according to any one of Claims 1 to 4, wherein the ratio of the cross-sectional area of one or a plurality of Nb or Nb-based alloy filaments disposed in each superconducting composite element to the cross-sectional area of the Cu-Sn-based alloy matrix is 30% to 50%.

6. The Nb₃Sn superconducting wire precursor according to any one of Claims 1 to 5, wherein the ratio of the cross-sectional area of one or a plurality of Ta or Ta-based filaments disposed in each reinforcing composite element to the cross-sectional area of the Cu-Sn-based alloy matrix is 30% to 300%.

7. The Nb₃Sn superconducting wire precursor according to any one of Claims 1 to 6, wherein the diffusion barrier layer is composed of Nb or a Nb-based alloy, or Ta or a Ta-based alloy.

8. A Nb₃Sn superconducting wire fabricated by a bronze process in which a Nb₃Sn superconducting phase is formed by the diffusion heat-treatment to the superconducting wire precursor according to any one of Claims 1 to 7.

## Patentansprüche

1. Nb₃Sn-Supraleitdrahtvorläufer, verwendet zum Herstellen eines Nb₃Sn-Supraleitdrahts durch ein Bronzeverfahren, wobei der Vorläufer in der Form eines Drahts ist, umfassend:
ein Aggregat, erhalten durch Bündeln von (A) einer Mehrzahl von supraleitenden Verbundelementen, jedes einschließend eine oder eine Mehrzahl von Fasern aus Nb oder aus auf Nb-basierter Legierung, angeordnet in einer Matrix aus Cu-Sn-basierter Legierung, und (B) eine Mehrzahl von verstärkenden Verbundelementen, jedes einschließend eine oder eine Mehrzahl von Fasern aus Ta oder aus auf Ta-basierter Legierung, angeordnet in einer Matrix aus Cu-Sn-basierter Legierung;
eine Diffusionsbarriereschicht, angeordnet in der Peripherie des Aggregats; und stabilisierendes Kupfer, angeordnet in der Peripherie der Diffusionsbarriereschicht, **dadurch gekennzeichnet, dass**
das Verhältnis der Querschnittsfläche der Fasern aus Ta oder aus auf Ta-basierter Legierung, angeordnet in den verstärkenden Verbundelementen, zu der Querschnittsfläche des Vorläuferdrahts 2% bis 15% beträgt, und die verstärkenden Verbundelemente bei einer Position in einem Bereich von 0,7D bis 0,9D in der radialen Richtung vorliegen, wobei D ein Außendurchmesser des Vorläuferdrahts ist.

2. Nb₃Sn-Supraleitdrahtvorläufer nach Anspruch 1, wobei die verstärkenden Verbundelemente fortlaufend über die gesamte Peripherie in der Umfangsrichtung des Querschnitts des Vorläuferdrahts angeordnet sind.

3. Nb₃Sn-Supraleitdrahtvorläufer nach Anspruch 1 oder 2, wobei die verstärkenden Verbundelemente in einem Bereich zwischen den supraleitenden Verbundelementen und der Diffusionsbarriereschicht angeordnet sind.

4. Nb₃Sn-Supraleitdrahtvorläufer nach einem der Ansprüche 1 bis 3, wobei die verstärkenden Verbundelemente die gleiche hexagonale Querschnittssaußenform wie die supraleitenden Verbundelemente aufweisen.

5. Nb₃Sn-Supraleitdrahtvorläufer nach einem der Ansprüche 1 bis 4, wobei das Verhältnis der Querschnittsfläche einer oder einer Mehrzahl von Fasern aus Nb oder aus auf Nb-basierter Legierung, angeordnet in jedem supraleitenden Verbundelement, zu der Querschnittsfläche der Matrix aus Cu-Sn-basierter Legierung von 30% bis 50% beträgt.

6. Nb₃Sn-Supraleitdrahtvorläufer nach einem der Ansprüche 1 bis 5, wobei das Verhältnis der Querschnittsfläche einer oder einer Mehrzahl von Fasern aus Ta oder auf Ta-Basis, angeordnet in jedem verstärkenden Verbundelement, zu der Querschnittsfläche der Matrix aus Cu-Sn-basierter Legierung von 30% bis 300% beträgt.

7. Nb₃Sn-Supraleitdrahtvorläufer nach einem der Ansprüche 1 bis 6, wobei die Diffusionsbarriereschicht aus Nb oder aus einer Nb-basierten Legierung, oder aus Ta oder aus einer Ta-basierten Legierung besteht.

8. Nb₃Sn-Supraleitdraht, hergestellt durch ein Bronzeverfahren, in welchem eine Nb₃Sn-supraleitende Phase durch die Diffusionswärmebehandlung des Supraleitdrahtvorläufers nach einem der Ansprüche 1 bis 7 gebildet wird.

## Revendications

1. Précurseur de câble supraconducteur en Nb₃Sn utilisé pour fabriquer un câble supraconducteur en Nb₃Sn par un procédé de bronze, le précurseur ayant la forme d'un câble, comprenant :
un agrégat obtenu par bottelage (A) d'une série d'éléments composites supraconducteurs, chacun comprenant un ou une série de filaments en Nb ou alliage à base de Nb disposés dans une matrice d'alliage Cu-Sn et (B) d'une série d'éléments composites de renforcement, chacun comprenant un ou une série de filaments en Ta ou en alliage à base de Ta disposés dans une matrice d'alliage à base de Cu-Sn ;
une couche de barrière de diffusion disposée dans la périphérie de l'agrégat, et
du cuivre stabilisant agencé à la périphérie de la couche de barrière de diffusion, **caractérisé en ce que**
le rapport de la surface en coupe transversale des filaments en Ta ou en alliage à base de Ta disposés dans les éléments composites de renforcement à la surface en coupe transversale du câble précurseur se situe dans l'intervalle allant de 2% à 15%, et les éléments composites de renforcement sont présents en une position située dans la plage allant de 0,7D à 0,9D en direction radiale, où D est le diamètre extérieur du câble précurseur.

2. Précurseur de câble supraconducteur en Nb₃Sn selon la revendication 1, où les éléments composites de renforcement sont disposés en continu sur toute la périphérie en direction de la circonférence de la coupe transversale du câble précurseur.

3. Précurseur de câble supraconducteur en Nb₃Sn selon la revendication 1 ou 2, où les éléments composites de renforcement sont disposés dans une région située entre les éléments composites supraconducteurs et la couche de barrière de diffusion.

4. Précurseur de câble supraconducteur en Nb₃Sn selon l'une quelconque des revendications 1 à 3, où les éléments composites de renforcement ont la même forme extérieure à coupe transversale hexagonale que les éléments composites supraconducteurs.

5. Précurseur de câble supraconducteur en Nb₃Sn selon l'une quelconque des revendications 1 à 4, où le rapport de la surface en coupe transversale d'un ou d'une série de filaments en Nb ou alliage à base de Nb disposés dans chaque élément composite supraconducteur à la surface en coupe transversale de la matrice en alliage à base de Cu-Sn se situe dans l'intervalle allant de 30% à 50%.

6. Précurseur de câble supraconducteur en Nb₃Sn selon l'une quelconque des revendications 1 à 5, où le rapport de la surface en coupe transversale d'un ou d'une série de filaments en Ta ou alliage à base de Ta disposés dans chaque élément composite de renforcement à la surface en coupe transversale de la matrice en alliage à base de Cu-Sn se situe dans l'intervalle allant de 30% à 300%.

7. Précurseur de câble supraconducteur en Nb₃Sn selon l'une quelconque des revendications 1 à 6, où la couche de barrière de diffusion est composée de Nb ou d'un alliage à base de Nb, ou de Ta ou d'un alliage à base de Ta.

8. Câble supraconducteur en Nb₃Sn fabriqué par un procédé de bronze, dans lequel une phase supraconductrice en Nb₃Sn est formée par diffusion par traitement thermique du précurseur de câble supraconducteur selon l'une quelconque des revendications 1 à 7.
